# EUROPEAN PATENT APPLICATION

(11) **EP 4 478 065 A1**
(43) Date of publication of application: **18.12.2024**
(21) Application number: 23774305.9
(22) Date of filing: 14.02.2023
(51) Int. Cl.: G01R 31/12

(54) **PARTIAL DISCHARGE DETECTOR**

(30) Priority: 24.03.2022 JP 2022048110
(71) Applicant: JFE Steel Corporation, Tokyo 100-0011 (JP)
(72) Inventor: SUENAGA Kiyoka, Yokkaichi-shi, Mie 510-0045 (JP)
(74) Representative: Hoffmann Eitle
(86) International application number: PCT/JP2023/004874
(87) International publication number: WO 2023/181706

(57) **Abstract**

Partial discharge is detected with high accuracy. An electrode 101 is affixed to a front surface 120s of a main body 120, which constitutes a housing of a detection sensor 100, and a dielectric is affixed to a front surface thereof. Magnets 107 are inserted into recessed portions 123 provided at the four corners of the main body. When the detection sensor 100 is mounted on electrical equipment, which incorporates a transformer or switchboard, so that the dielectric is in contact with an outer surface of the electrical equipment, an electrostatic coupling occurs between the electrical equipment and the electrode, thus enabling, with high sensitivity, the detection of a change in ground voltage due to partial discharge occurring in the switchboard. In noisy environment, the detection sensor 100 is mounted so that a back surface side of the detection sensor 100 is in contact with an inner surface of the electrical equipment, and a metal antenna plate is mounted on front surfaces of the electrode 101 and the dielectric. This enables the detection of partial discharge occurring inside while blocking external noise by the electrical equipment. Therefore, the partial discharge can be detected with high accuracy.

## Description

### TECHNICAL FIELD

The present disclosure relates to technology for detecting partial discharge that occurs in electrical equipment covering transformers or switchboards.

### BACKGROUND ART

In electrical equipment, such as transformers or switchboards, that handles high-voltage electricity, wires and various other parts are insulated as appropriate with insulating materials. Aged deterioration or damage occurring in the insulating materials may cause pulsed weak electrical discharge to occur at those parts due to partial short circuits. In order to keep the electrical equipment in proper condition, it is desirable to detect this partial discharge and perform maintenance as soon as possible.

Transient earth voltage (TEV) sensors are known as sensors for detecting the partial discharge. The TEV sensors are sensors that detect changes in ground voltage that occur due to the partial discharge in the electrical equipment. The TEV sensor is conventionally configured with an electrode provided inside a housing. When the TEV sensor is mounted on the electrical equipment, the electrical equipment and the electrode are placed at a predetermined distance from each other. Taking advantage of an electrostatic coupling occurring between the electrical equipment and the electrode, the TEV sensor detects, with the electrode, a change in the ground voltage of the electrical equipment. Patent Literature (PTL) 1 discloses technology for detection with the reduced frequency of a waveform signal detected by the TEV sensor.

### CITATION LIST

### Patent Literature

PTL 1: JP 2021-25881 A

### SUMMARY

### (Technical Problem)

However, conventional TEV sensors have poor sensitivity, making it difficult to ensure accuracy in detection of partial discharge. Also, the conventional TEV sensors have high susceptibility to ambient noise. Furthermore, the partial discharge takes the form of very high-frequency pulses. To detect such partial discharge, detection and sampling must be performed at a high frequency, which tends to make a detection apparatus more expensive and increase power consumption required for the detection.

The present disclosure is made in view of these issues and aims to solve at least some of these issues in the detection of the partial discharge.

### (Solution to Problem)

As a first aspect, the present disclosure can be configured as:
a partial discharge detector configured to detect partial discharge occurring inside electrical equipment covering a transformer or switchboard, the partial discharge detector including:
an electrode composed of a metal plate;
a dielectric film affixed to a surface of the electrode; and
a housing configured to mount the electrode on the electrical equipment with the film facing a side of the switchboard.

In the first aspect, when the electrode is mounted on the electrical equipment, a dielectric is interposed between the electrode and the electrical equipment. When the partial discharge occurs inside the electrical equipment and electromagnetic waves generated thereby reach the electrical equipment, a change in ground voltage occurring in the electrical equipment is detected by the electrode, which is electrostatically coupled to the electrical equipment. Here, in the first aspect, the dielectric interposed between the electrical equipment and the electrode increases the capacitance of the electrode and thus increases sensitivity. Therefore, according to the first aspect, it is possible to detect, with high sensitivity, the partial discharge occurring inside the electrical equipment.

In the present disclosure, ones with a variety of material properties can be used as the dielectric, and
the film may be made of fluoroplastic.

The fluoroplastic is suitable because of relative ease of obtainment and handling, and having a sufficient relative dielectric constant to improve the sensitivity. As an example, a material in which a glass fiber sheet substrate is coated with the fluoroplastic can be used.

It has been found that as the relative dielectric constant increases, the detection sensitivity of the ground voltage is improved, but a frequency band with high detection sensitivity shifts to a lower frequency side. In this sense, it does not mean that the higher the relative dielectric constant, the better. An optimal value should be selected in consideration of both the sensitivity and the frequency band. The fluoroplastic can be said to be a suitable material for the present disclosure from this perspective as well.

In the present disclosure,
the partial discharge detector may be configured to have a capacitance of 200 pF or more when mounted on the electrical equipment.

By measuring increase in the detection sensitivity of the ground voltage with increasing the capacitance, it has been confirmed that the overall sensitivity increases monotonically with increasing the capacitance. It has also been confirmed that the sensitivity increases very steeply up to a capacitance of approximately 200 pF, whereas the sensitivity increases gently at capacitances of over approximately 200 pF. Therefore, it is considered that sufficient sensitivity improvement can be obtained by setting the capacitance at 200 pF or more.

To increase the capacitance, there are conceivable methods of increasing the area of the electrode, increasing the relative dielectric constant of the dielectric, narrowing the distance between the electrode and the electrical equipment (making the dielectric thinner), and the like. Any of these methods may be employed, or a combination of the methods may be employed.

However, trying to achieve a capacitance of 200 pF, i.e. approximately 20 times a conventional capacitance (approximately 11 pF), only by increasing the area of the electrode has to increase the area of the electrode by 20 times, resulting in a very large detection sensor. In the present disclosure, the use of the dielectric is also useful to increase the sensitivity while suppressing the size of the detection sensor.

In the present disclosure,
the housing may be in the shape of a box,
the electrode may be affixed to one surface of the housing, and
the film may be affixed to an outer surface of the electrode.

This makes it easier to handle the housing, the electrode, and the film as a single sensor. Conventional TEV sensors are generally provided with an electrode inside a housing in order to maintain a distance between the electrode and the electrical equipment. In the present disclosure, however, the electrode can be mounted on the outer surface of the housing because the surface of the electrode is provided with the dielectric film. As a result, while taking the easy-to-handle form of the box-shaped housing, it is possible to dispose the electrical equipment and the electrode close together through the dielectric, thereby improving the detection sensitivity.

To mount the housing on the electrical equipment, various methods including methods of using magnetic force, adhesion, bonding, suction cups, screws, or other fixtures can be used. A method of mounting a magnet on the housing and mounting the housing on the electrical equipment using this magnetic force is suitable in terms of ease of handling.

As a second aspect, the present disclosure can be configured as:
a partial discharge detector configured to detect partial discharge occurring inside electrical equipment covering a transformer or switchboard, the partial discharge detector including:
an electrode composed of a metal plate;
an antenna plate composed of a metal plate; and
a housing configured to hold the electrode and the antenna plate parallel to each other at a first distance, and to mount the electrode on the electrical equipment at a second distance from the electrical equipment.

According to the second aspect, since the housing has the electrode and the antenna plate, electromagnetic waves caused by the partial discharge occurring inside the electrical equipment can be captured by the antenna plate, and ground voltage can be detected by the electrode.

Conventional TEV sensors capture, by the electrical equipment, the electromagnetic waves caused by the partial discharge, and detect the ground voltage caused thereby. However, when the electrical equipment is installed in environment with a lot of external noise, the electrical equipment captures both the external noise and the partial discharge. This makes it difficult for the partial discharge detector to distinguish between the partial discharge and the noise, resulting in low detection accuracy for the partial discharge.

In contrast, in the second aspect, mounting the partial discharge detector on the inside of the electrical equipment allows the antenna plate to capture the partial discharge inside the electrical equipment, while allowing the electrical equipment to block noise from outside. Therefore, the partial discharge can be detected with high accuracy without being affected by the noise.

The first distance between the electrode and the antenna plate can be set arbitrarily, but from the perspective of increasing the detection sensitivity, the first distance is preferably narrower.

The second distance between the electrical equipment and the electrode can also be set arbitrarily, but from the perspective of avoiding the influence of noise, the second distance is preferably wider.

In the second aspect of the present disclosure,
a dielectric film may be provided between the electrode and the antenna plate.

Therefore, the detection sensitivity can increase, as in the first aspect.

In the second aspect of the present disclosure,
the antenna plate may be removably mounted, and
when the antenna plate is removed, the housing may be able to mount the electrode on the electrical equipment at a third distance, which is narrower than the second distance.

With the antenna plate mounted, the partial discharge detector can detect the partial discharge by being mounted on the inside of the electrical equipment. This aspect is useful in noisy environment.

On the other hand, when the antenna plate is removed, the partial discharge detector can detect the partial discharge by being mounted on the outside (or inside) of the electrical equipment, by utilizing the electrical equipment itself as an antenna. This aspect is useful in environment with low noise.

By making the antenna removable, as described above, it is possible to switch the aspect of use depending on the environment, to mount the partial discharge detector on the inside or outside of the electrical equipment.

The third distance can be determined arbitrarily to the extent that the electrical equipment and the electrode can be coupled electrostatically. The third distance may be the same as or different from the first distance.

As one aspect, the partial discharge detector according to the present disclosure may be mounted so that a surface opposite the electrode is affixed to the electrical equipment when the antenna plate is mounted, and may be flipped over and mounted so that the electrode side is affixed to the electrical equipment when the antenna plate is removed.

As another aspect, the partial discharge detector may also be able to vary the thickness of the housing. In such an aspect, the partial discharge detector with the thicker housing can be mounted on the inside of the electrical equipment to avoid the influence of noise, and the partial discharge detector with the thinner housing can be mounted on the outside of the electrical equipment to enable electrostatic coupling.

In the second aspect of the present disclosure,
the housing is in the shape of a box, and has a magnet with a length extending from a front surface to a back surface of the housing, and
the electrode is affixed to the front surface in such a position as to avoid the magnet.

According to the above aspect, the housing can be mounted on the electrical equipment with facing either the front or the back. It also has the advantage of a simplified structure because of the use of the magnet with the length extending from the front surface to the back surface.

Not limited to the above structure, the magnet may be provided on each of the front and back surfaces of the housing.

In the second aspect of the present disclosure,
the antenna plate may be removably mounted with the magnet.

This allows the antenna plate to be removed relatively easily. As described above, when the magnet extending from the front surface to the back surface is used, this magnet may be utilized.

The first and second aspects of the present disclosure may further include:
a conversion circuit configured to reduce the frequency of a detection signal detected at the electrode.

The partial discharge usually takes the form of very high-frequency pulses. To detect the partial discharge, the detection and the transmission of the detection result must be performed at a high frequency, which causes increase in power consumption. In contrast, according to the above aspect, the frequency of the detection signal can be reduced by the conversion circuit, thus allowing curbing the power consumption.

In the second aspect of the present disclosure,
the conversion circuit may be a circuit that is in tune with the detection signal of 10 MHz to 20 MHz.

It has been found that a partial discharge signal detected by the partial discharge detector has peaks at 10 MHz to 20 MHz and at 50 MHz to 100 MHz. When the frequency is reduced to curb the power consumption, the 10 MHz to 20 MHz band is easier to convert than the 50 MHz to 100 MHz band. The above aspect has the advantage of detecting the frequency of the partial discharge as well as converting the frequency to a lower frequency with high efficiency.

In the second aspect of the present disclosure,
the conversion circuit may be an amplitude modulation circuit that includes a tuning circuit, a high-frequency amplification circuit, a detection circuit, and a low-frequency amplification circuit.

Thereby, the frequency can be reduced. The amplitude modulation circuit described above also has the advantage of being obtained relatively inexpensively due to the presence of a single IC chip.

As a third aspect, the present disclosure can be configured as:
a partial discharge detection system configured to detect partial discharge occurring inside electrical equipment covering a transformer or switchboard, the partial discharge detection system including:
the partial discharge detector in any of the above aspects; and
an analyzer configured to analyze the presence or absence of the partial discharge based on output of the partial discharge detector.

According to the third aspect, the partial discharge can be detected by analysis by the analyzer. The analysis can be performed by various methods.

Further, in the third aspect of the present disclosure,
the partial discharge detector may be provided with a wireless communication apparatus configured to wirelessly communicate the output to the analyzer.

According to the above aspect, the output can be transmitted wirelessly, which improves the convenience of the partial discharge detector.

The present disclosure does not necessarily have to provide with all of the various features described above, and some of the features may be omitted or combined as appropriate.

### BRIEF DESCRIPTION OF THE DRAWINGS

In the accompanying drawings:
FIG. 1 is an explanatory view illustrating a configuration of a partial discharge detection system;
FIGS. 2A and 2B are explanatory views illustrating a configuration of a detection sensor;
FIGS. 3A and 3B are explanatory views illustrating usage aspects of the detection sensor;
FIG. 4 is a graph illustrating the influence of noise depending on a housing thickness;
FIG. 5 is a graph illustrating the relationship between capacitance and sensitivity;
FIGS. 6A and 6B are explanatory views illustrating the relationship between the material property and the capacitance of dielectrics;
FIGS. 7A and 7B are explanatory views illustrating a configuration of a communication apparatus;
FIGS. 8A to 8C are explanatory views illustrating the action of a conversion circuit; and
FIG. 9 is a flowchart of a discharge detection process.

### DETAILED DESCRIPTION

An embodiment of the present disclosure will be described below with taking as an example a system to detect partial discharge occurring in a switchboard.

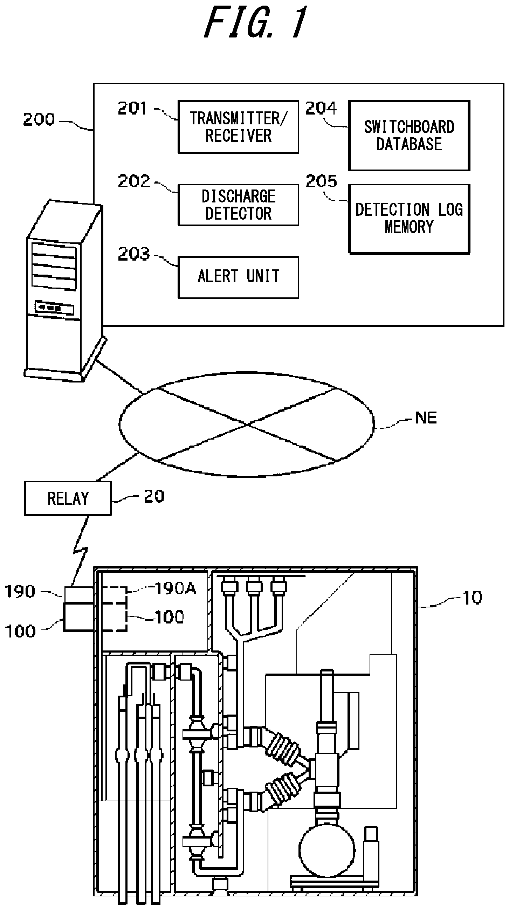

FIG. 1 is an explanatory view illustrating a configuration of a partial discharge detection system. Electrical equipment 10 is equipment in which a switchboard, which transforms high voltage sent from an electric power company, is contained in a box.

On a door of the electrical equipment 10, a detection sensor 100, which detects partial discharge, and a communication apparatus 190, which wirelessly communicates a detected signal, are mounted. The detection sensor 100 and the communication apparatus 190 correspond to a partial discharge detector.

The detected signal is transmitted from the communication apparatus 190, through a relay 20, to an analyzer 200 via a network NE. The relay 20 is a device for connecting the communication apparatus 190 to the network NE, and various well-known devices can be used.

The detection sensor 100 and the analyzer 200 can be connected in various ways, and the communication apparatus 190 and the analyzer 200 can be directly connected wirelessly or with wires. Both of the detection sensor 100 and the analyzer 200 may also be configured as a single unit.

The detection sensor 100 can be mounted on the outside of the electrical equipment 10, as illustrated in solid lines in the figure, or on the inside of the electrical equipment 10, as illustrated in dashed lines. When the detection sensor 100 is mounted on the inside, the communication apparatus 190A is also mounted on the inside. However, it is preferable that the communication apparatus 190A be configured to allow communication even when mounted on the inside of the electrical equipment 10. For example, a configuration to convey a detection signal to the communication apparatus 190 via electricity, light, or sound through the door of the electrical equipment 10 may be added.

Configurations of the detection sensor 100 and the communication apparatus 190 will be described below.

The analyzer 200 is built in software by installing a program that implements each of functions illustrated in the figure on a server. Some or all of the functions may be configured in hardware.

Each of the functions illustrated in the figure will be described.

A transmitter/receiver 201 performs the function of transmitting and receiving signals to and from the detection sensor 100 or the like via the network NE.

A discharge detector 202 analyzes, based on a signal detected by the detection sensor 100, whether the signal corresponds to partial discharge.

An alert unit 203 outputs an alert when the partial discharge is detected, and when it is determined that there is an abnormality in the switchboard. The alert can be output in various methods, for example, by transmitting an e-mail to a predetermined notification destination.

A switchboard database 204 is a database that stores information on the switchboard, i.e., the electrical equipment 10. For example, information that identifies a switchboard, such as its location and name, is stored in correspondence with an identifier attached to the switchboard. This makes it possible to easily identify which switchboard a detection result is from, by receiving, from the detection sensor 100, the detection result together with the identifier.

A detection log memory 205 stores past detection results for each switchboard. By storing the past detection results, for example, it is possible to check how often the partial discharge occurs and to analyze whether there is an abnormality in the switchboard.

The partial discharge detection system is not limited to the configuration illustrated in FIG. 1, but can take various configurations. Additional functions other than those illustrated may be added.

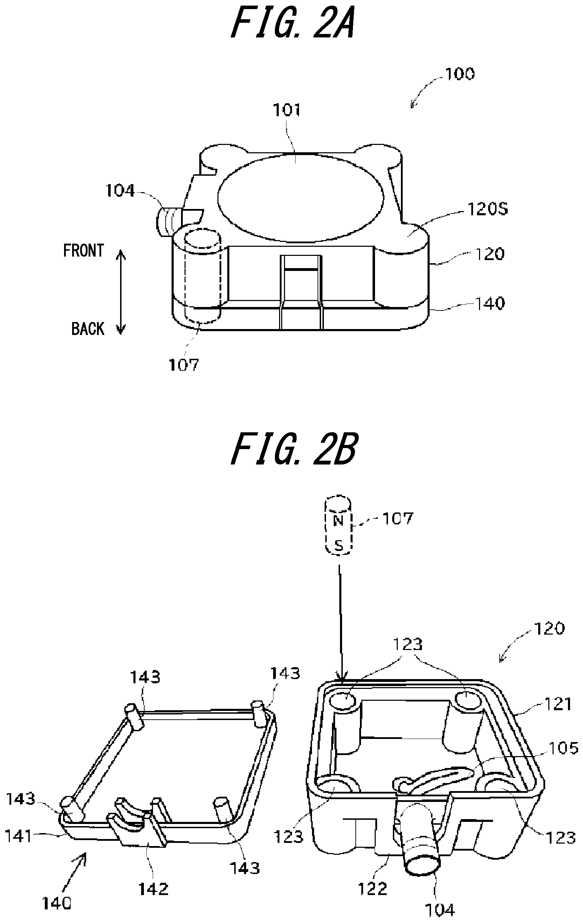

FIGS. 2A and 2B are explanatory views illustrating the configuration of the detection sensor 100.

FIG. 2A illustrates a perspective view. A housing of the detection sensor 100 is constituted of a main body 120 and a lid 140. For the sake of explanation, an upper side of the housing in the figure is referred to as a front side and a lower side as a back side.

To a front surface 120s of the main body 120, which constitutes the housing, an electrode 101 of a metal plate is affixed. A dielectric is affixed to a front surface of the electrode 101. The surface to which the electrode 101 is affixed is hereinafter referred to as a front surface, and the opposite side is referred to as a back surface.

Magnets 107 with a length extending from the front surface to the back surface are embedded at four corners of the housing. With magnetic force of the magnets 107, the detection sensor 100 can be mounted on the electrical equipment 10 in either orientation on the front or back surface.

The main body 120 of the housing is provided with a terminal 104 for outputting a detection signal. The terminal 104 and the electrode 101 are connected with a wire inside the main body 120.

FIG. 2B illustrates the internal structure of the detection sensor 100 with the main body 120 and the lid 140 removed. In a side surface 121 of the main body 120, a mounting portion 122 for mounting the terminal 104 is formed. The electrode and the terminal 104 are connected with a wire 105.

Recessed portions 123 are provided at the four corners of the main body 120. Into each recessed portion 123, the cylindrical magnet 107 is inserted. In the lid 140, a mounting portion 142 for holding the terminal 104 is formed on a side surface 141. Convex portions 143 for holding the magnets 107 are formed at the four corners of the lid 140.

The lid 140 holds the magnets 107 and terminal 104, as described above, so it is possible to easily configure the detection sensor 100 without using screws or other parts.

The shape and structure of the detection sensor 100 are not limited to the example described above. The magnets 107 may be divided and mounted on the front and back surfaces.

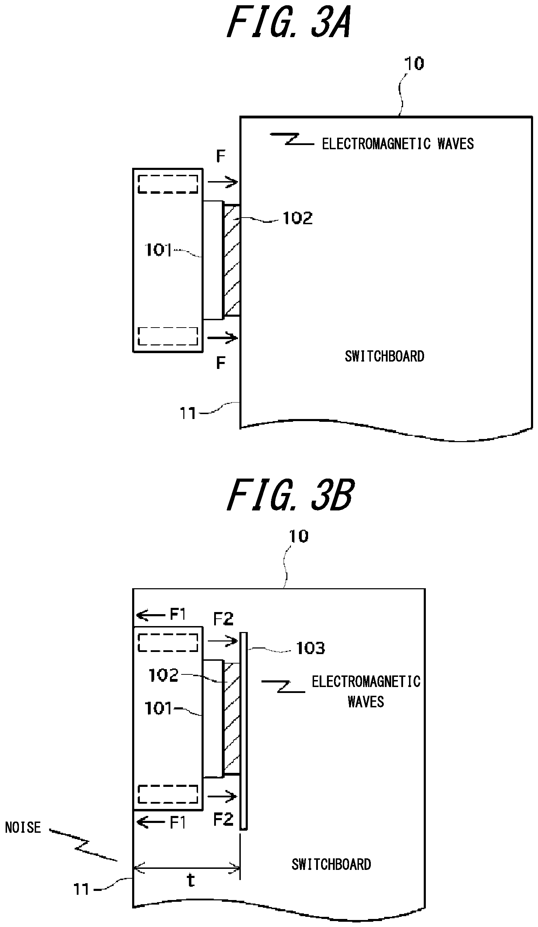

FIGS. 3A and 3B are explanatory views illustrating usage aspects of the detection sensor.

FIG. 3A illustrates the detection sensor 100 mounted on the outside of the door 11 of the electrical equipment 10. At this time, the detection sensor 100 is mounted, by magnetic force F of the magnets 107, with the front surface facing the door 11. Since a dielectric 102 is affixed to the front surface of the electrode 101, by mounting the detection sensor 100 on the door 11, the dielectric 102 is sandwiched between the door 11 and the electrode 101.

As a result, when the partial discharge occurs in the switchboard in the electrical equipment 10, its electromagnetic waves are captured by the door 11 and detected by the detection sensor 100. The interposition of the dielectric 102 increases the capacitance of the electrode 101, which increases detection sensitivity.

FIG. 3B illustrates the detection sensor 100 mounted on the inside of the door 11 of the electrical equipment 10. At this time, the detection sensor 100 is mounted, by magnetic force F1 of the magnets 107, with the back surface facing the door 11. In the front surface, an antenna plate 103 is mounted on the front surfaces of the electrode 101 and the dielectric 102 by magnetic force F2 of the magnets 107. The antenna plate 103 is a metal plate larger than the electrode 101. When the detection sensor 100 is mounted on the inside of the electrical equipment 10, the dielectric 102 is sandwiched between the electrode 101 and the antenna plate 103.

As a result, when the partial discharge occurs in the switchboard in the electrical equipment 10, the electromagnetic waves are captured by the antenna plate 103 and detected by the detection sensor 100. The interposition of the dielectric 102 increases the capacitance of the electrode 101, which increases the detection sensitivity.

When the electrical equipment 10 is installed in noisy environment, noise is captured by the door 11 of the electrical equipment 10, as illustrated in the figure. The door 11 also performs the function of shielding the noise. The housing of the detection sensor 100 also performs the function of isolating the antenna plate 103, which captures the partial discharge, at a distance t from the door 11. Therefore, as illustrated in FIG. 3B, the detection sensor 100 according to the embodiment can detect the partial discharge with suppressing the influence of noise by being mounted on the inside of the door 11.

The distance t from the door 11 to the antenna plate 103 (referred to as housing thickness t) can be determined arbitrarily, taking the influence of noise and other factors into consideration.

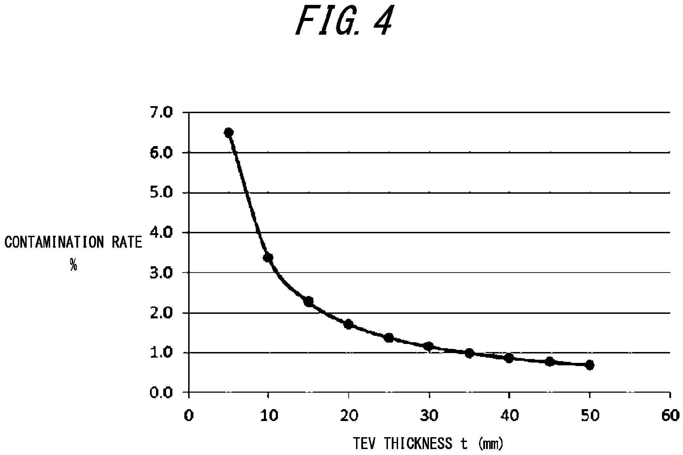

FIG. 4 is a graph illustrating the influence of noise depending on the housing thickness. As illustrated in the figure, a noise contamination rate decreases monotonically as the housing thickness t increases. To sufficiently reduce noise, the housing thickness t is preferably set to 10 mm or more. However, since the increased housing thickness results in upsizing of the detection sensor 100, it is preferable to take this into consideration when determining the housing thickness.

As described earlier, in the detection sensor 100, the dielectric 102 is affixed to the front surface of the electrode 101. This improves the detection sensitivity.

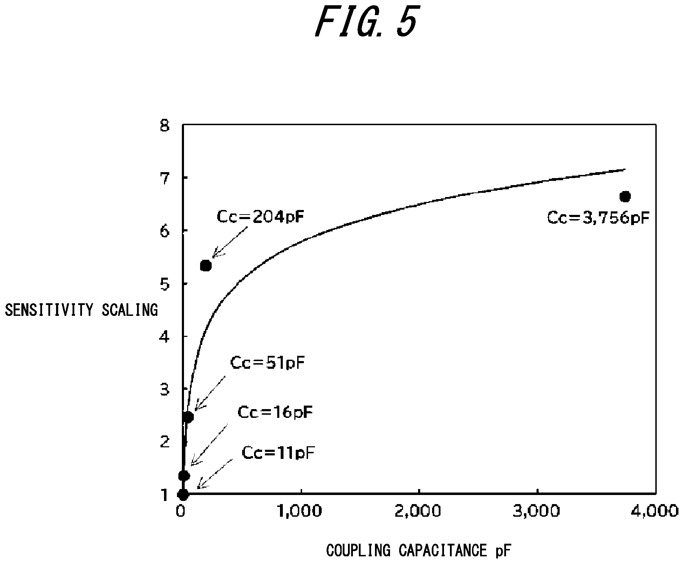

FIG. 5 is a graph illustrating the relationship between the capacitance and the sensitivity. The vertical axis represents a sensitivity scaling based on the sensitivity of a conventional TEV sensor (coupling capacitance of the order of 11 pF). As illustrated in the figure, the sensitivity of the detection sensor 100 increases monotonically as the capacitance increases. However, the sensitivity of the detection sensor 100 does not increase linearly, but rather, in the range of the capacitance up to 204 pF, the sensitivity significantly increases to approximately 5 times by a slight increase in the capacitance, and in the range exceeding this, the influence by the increase in the capacitance becomes moderate and the sensitivity does not increase so significantly even when the capacitance increases. Therefore, in terms of obtaining sufficient sensitivity as the detection sensor 100, the capacitance is preferably set at approximately 200 pF or more.

In the detection sensor 100, various materials can be used as the dielectric 102. In the embodiment, the following three materials are tested to select a material suitable for the detection sensor 100.

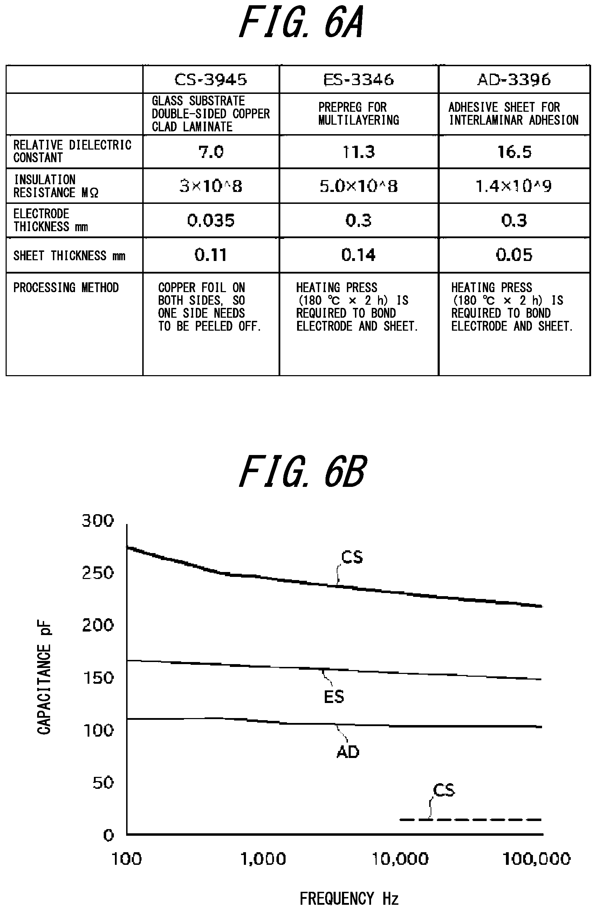

FIGS. 6A and 6B are explanatory views illustrating the relationship between the material property and the capacitance of dielectrics. As illustrated in FIG. 6A, CS-3945^{®}, ES-3346^{®}, and AD-3396^{®} (all of CS-3945, ES-3346, and AD-3396 are trademarks in Japan, other countries, or both) are used in the embodiment. Characteristics, such as a relative dielectric constant and a sheet thickness, are illustrated in the table in FIG. 6A.

FIG. 6B illustrates the capacitance in the case of using these materials. In the table, a curve A is the capacitance of the conventional TEV sensor. As illustrated in the figure, the capacitance is lowered in the order of CS-3945^{®}, ES-3346^{®}, and AD-3396^{®}. It has been found that when CS-3945^{®} is used, the capacitance exceeds 200 pF.

As illustrated in FIG. 6A, the relative dielectric constant is increased in the order of CS-3945^{®}, ES-3346^{®}, and AD-3396^{®}, but the material thickness becomes thinner in that order, so the overall capacitance of CS-3945^{®} is the largest. Thus, both the relative dielectric constant and the thickness of the material concern with the capacitance. The example illustrated in the embodiment is just one example, and materials with various relative dielectric constants and material thicknesses can be selected.

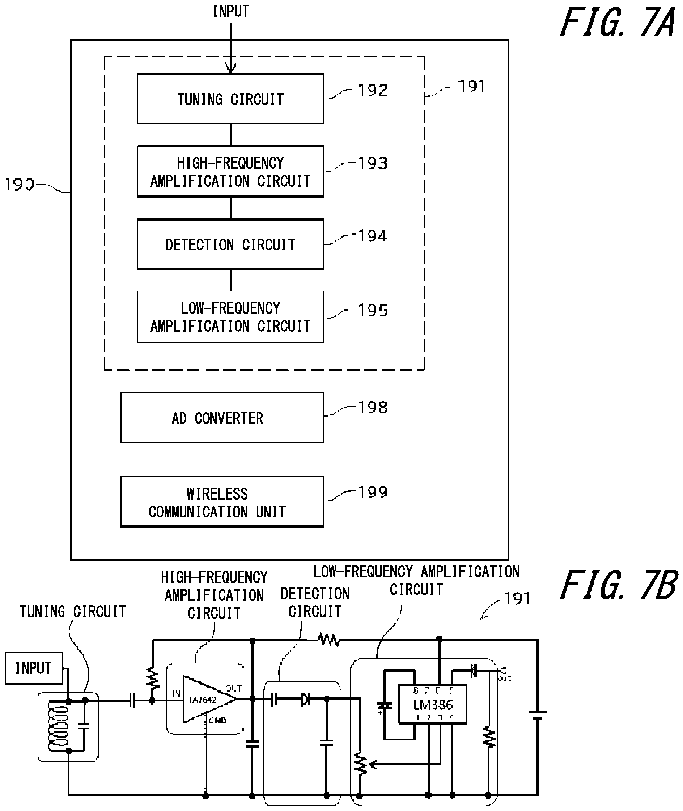

FIGS. 7A and 7B are explanatory views illustrating the configuration of the communication apparatus 190. FIG. 7A illustrates the schematic configuration of the communication apparatus 190. As illustrated in the figure, the communication apparatus 190 is provided with a conversion circuit 191, an AD converter 198, and a wireless communication unit 199.

The conversion circuit 191 is a circuit for converting a high-frequency input signal into a low-frequency signal. The conversion circuit 191 includes a tuning circuit 192, a high-frequency amplification circuit 193, a detection circuit 194, and a low-frequency amplification circuit 195.

FIG. 7B illustrates the specific circuit configuration. The tuning circuit 192 can be in tune with a wide range of frequencies by increasing the Q value. In the embodiment, the circuit is designed to be in tune with 10 MHz to 20 MHz, as described below.

In this embodiment, an IC chip for amplitude modulation, which constitutes the conversion circuit 191, is used. The conversion circuit can be thereby configured inexpensively and simply. The conversion circuit 191 is not limited to such a configuration, but various configurations that convert a high-frequency input signal into a low-frequency signal can be applied.

The AD converter 198 converts the low-frequency output signal converted by the conversion circuit 191 into a digital signal.

The wireless communication unit 199 wirelessly transmits the converted digital signal.

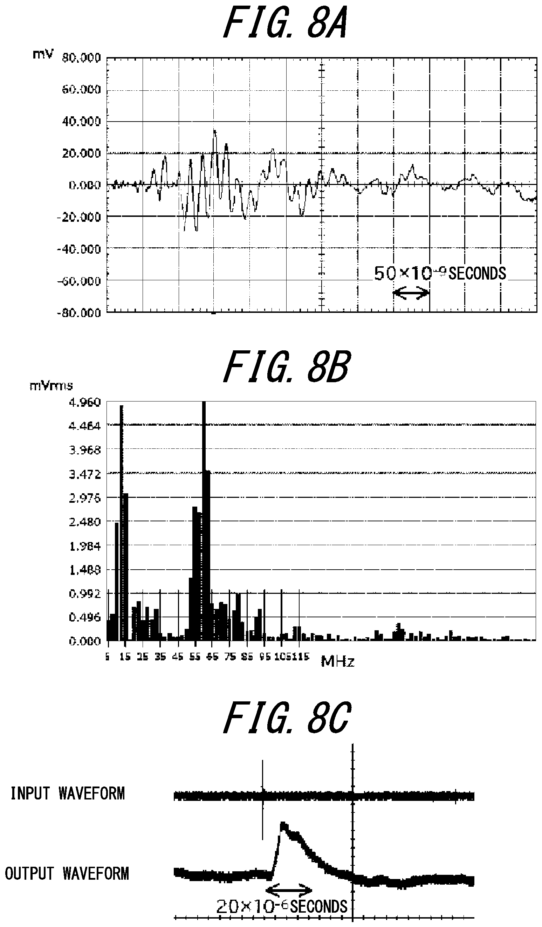

FIGS. 8A to 8C are explanatory views illustrating the action of the conversion circuit 191. FIG. 8A illustrates an output signal from the detection sensor 100 when partial discharge is detected. As illustrated in the figure, the output signal has components of various frequencies.

FIG. 8B illustrates the strength distribution of the output signal at each frequency. As illustrated in the figure, it has been found that the output signal of the partial discharge has peaks of intensity at 10 MHz to 20 MHz and at 50 MHz to 100 MHz. Therefore, in order to detect the partial discharge with high accuracy, it is preferable to detect, by the tuning circuit 192, the frequencies of one or both of these two peaks. In this embodiment, the circuit is configured to be in tune with 10 MHz to 20 MHz. This is because it is more efficient to convert a signal with lower frequencies of 10 MHz to 20 MHz to a low-frequency signal than to convert a signal with higher frequencies of 50 MHz to 100 MHz to a low-frequency signal. This is also because a tuning circuit for 10 MHz to 20 MHz can be realized at a lower cost.

FIG. 8C illustrates an input waveform to and an output waveform from the conversion circuit 191. The detection signal due to the partial discharge has a very high-frequency pulsed waveform as illustrated in the input waveform in FIG. 8C, though contains various frequencies as illustrated in FIGS. 8A and 8B. In the embodiment, this detection signal is converted into a low-frequency signal. The frequency after the conversion can be selected arbitrarily, but as an example, may be several tens of KHz, e.g., 50 KHz.

The reason for converting into the low-frequency signal is as follows. In order to detect the high-frequency pulsed detection signal as illustrated in FIG. 8C, it is necessary to perform sampling at a high frequency equivalent to this one, and then transmit the result of the detection at a higher frequency. Such a circuit is expensive, and the amount of data to be transmitted is also large, resulting in high power consumption. The embodiment avoids such issues by lowering the frequency, thus enabling the detection of the partial discharge at low cost and with low power consumption.

The analyzer 200 detects whether the transmitted detection signal corresponds to the partial discharge.

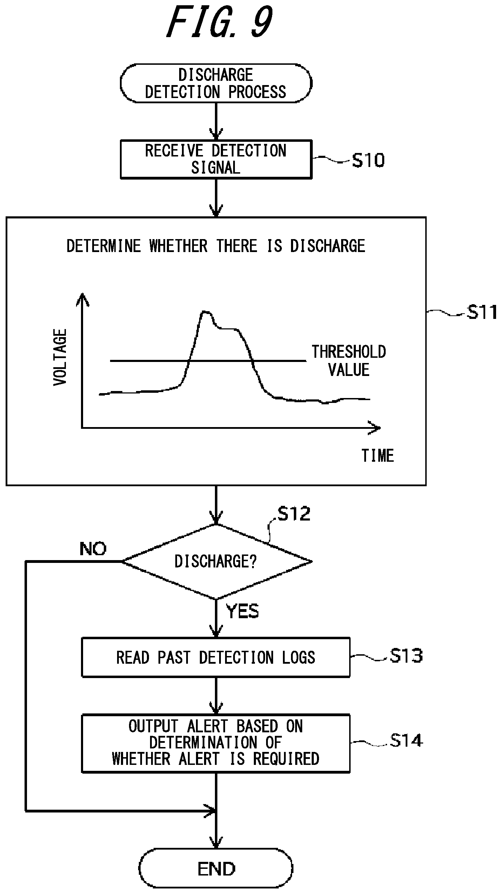

FIG. 9 is a flowchart of a discharge detection process. This is a process performed by the analyzer 200.

Upon starting the process, the analyzer 200 receives a detection signal (step S10), and determines whether there is a discharge (step S11). A method of determining the presence of the discharge is illustrated in the figure. As illustrated in the figure, as an example, it can be determined that there is a partial discharge when the strength of the detection signal exceeds a predetermined threshold value. The determination is not limited to such a method, but can be made by various other methods.

When no partial discharge is detected (step S12), the discharge detection process ends.

When the partial discharge is detected (step S12), the analyzer 200 reads past detection logs (step S13), and outputs an alert (step S14) based on the determination of whether an alert is required. Whether the alert is required can be determined based on, for example, the number of detections of past partial discharge, the frequency of the detections, or the like. The alert can be output, for example, by sending an e-mail to a predetermined notification destination.

According to the partial discharge detector and the partial discharge detection system in the embodiment described above, the partial discharge occurring at high frequencies can be detected with high accuracy at low cost and with low power consumption. The partial discharge detector is mounted on the outside of the electrical equipment when used in environment with low noise, and on the inside of the electrical equipment when used in noisy environment, thus enabling the detection with suppressing the influence of noise.

The partial discharge detector and the partial discharge detection system do not necessarily have to have all of the various features described in the embodiment, and may be configured by omitting or combining some of the features as appropriate.

### INDUSTRIAL APPLICABILITY

The present disclosure can be used to detect partial discharge that occurs in electrical equipment covering transformers or switchboards.

### REFERENCE SIGNS LIST

- 10: electrical equipment
- 11: door
- 20: relay
- 100: detection sensor
- 101: electrode
- 102: dielectric
- 103: antenna board
- 104: terminal
- 105: wire
- 107: magnet
- 120: main body
- 120s: front surface
- 121: side surface
- 122: mounting portion
- 123: recessed portion
- 140: lid
- 141: side surface
- 142: mounting portion
- 143: convex portion
- 190, 190A: communication apparatus
- 191: conversion circuit
- 192: tuning circuit
- 193: high-frequency amplification circuit
- 194: detection circuit
- 195: low-frequency amplification circuit
- 198: AD converter
- 199: wireless communication unit
- 200: analyzer
- 201: transmitter/receiver
- 202: discharge detector
- 203: alert unit
- 204: switchboard database
- 205: detection log memory

## Claims

1. A partial discharge detector configured to detect partial discharge occurring inside electrical equipment covering a transformer or switchboard, the partial discharge detector comprising:
an electrode composed of a metal plate;
a dielectric film affixed to a surface of the electrode; and
a housing configured to mount the electrode on the electrical equipment from outside the electrical equipment with the film facing a side of the switchboard,
wherein
the housing is in shape of a box,
the electrode is affixed to one surface of the housing, and
the film is affixed to an outer surface of the electrode.

2. The partial discharge detector according to claim 1, wherein the film is made of fluoroplastic.

3. The partial discharge detector according to claim 1, configured to have a capacitance of 200 pF or more when mounted on the electrical equipment.

4. The partial discharge detector according to claim 1, comprising:
a removable antenna plate composed of a metal plate,
wherein
the housing is configured to be able to be mounted so that a surface opposite the surface to which the electrode is affixed is in contact with an inside of the electrical equipment, and
in a mounted state,
the housing is configured to hold the electrode and the antenna plate parallel to each other at a first distance, and
the housing is configured to hold the electrode at a second distance from the electrical equipment.

5. The partial discharge detector according to claim 4, comprising a dielectric film provided between the electrode and the antenna plate.

6. The partial discharge detector according to claim 4, wherein
the housing has a magnet with a length extending from a front surface to a back surface of the housing, and
the electrode is affixed to the front surface in such a position as to avoid the magnet.

7. The partial discharge detector according to claim 6, wherein the antenna plate is removably mounted with the magnet.

8. The partial discharge detector according to any one of claim 1, further comprising a conversion circuit configured to reduce a frequency of a detection signal detected at the electrode.

9. The partial discharge detector according to claim 8, wherein the conversion circuit is a circuit that is in tune with the detection signal of 10 MHz to 20 MHz.

10. The partial discharge detector according to claim 8, wherein the conversion circuit is an amplitude modulation circuit that comprises a tuning circuit, a high-frequency amplification circuit, a detection circuit, and a low-frequency amplification circuit.

11. A partial discharge detection system configured to detect partial discharge occurring inside electrical equipment covering a transformer or switchboard, the partial discharge detection system comprising:
the partial discharge detector according to any one of claims 1 to 10; and
an analyzer configured to analyze presence or absence of the partial discharge based on output of the partial discharge detector.

12. The partial discharge detection system according to claim 11, further comprising a wireless communication apparatus configured to wirelessly communicate the output to the analyzer.
